# EUROPÄISCHE PATENTSCHRIFT

(11) **EP 1 584 128 B1**
(45) Veröffentlichungstag und Bekanntmachung des Hinweises auf die Patenterteilung: **06.01.2010**
(21) Anmeldenummer: 03767407.4
(22) Anmeldetag: 07.11.2003
(51) Int. Cl.: H02B 1/14

(54) **MODULARES INSTALLATIONSGERÄT**
MODULAR WIRING DEVICE
APPAREIL MODULAIRE D'INSTALLATION

(30) Priorität: 13.01.2003 DE 10301004
(43) Veröffentlichungstag der Anmeldung: 12.10.2005
(73) Patentinhaber: SIEMENS AKTIENGESELLSCHAFT, 80333 München (DE)
(72) Erfinder: FREIMUTH, Michael, 92242 Hirschau (DE); ROYER, Fritz, 92256 Hahnbach (DE)
(86) Internationale Anmeldenummer: PCT/DE2003/003694
(87) Internationale Veröffentlichungsnummer: WO 2004/068662

(56) Entgegenhaltungen:
- EP-A- 0 639 877
- EP-A- 1 058 348
- US-A- 5 168 137
- US-A- 5 655 922

## Beschreibung

Die Erfindung betrifft ein modulares Installationsgerät.

Aus dem Produktkatalog der Firma Phoenix mit der Bezeichnung "Leiterplattenanschluss COMBICON 2002" ist, z.B. gemäß der Seiten 3 und 318, ein mit einem Gehäuse und einem Hutschienenhalter versehenes, modulares Einbaugerät bekannt, das abnehmbare Schraubklemmenblöcke aufweist, die mit einer blockeinheitlichen Kodierung zur lagerichtigen Zuführung der Blöcke, krallenähnlichen Fortsätzen zur Fixierung an dem Gehäuse und mit axial zu kontaktierenden Kontaktnadeln versehen sind. Ein derartiges Einbaugerät findet beispielsweise als Reiheneinbaugerät in einem Schaltschrank Verwendung und dient als Schalt- und/oder Schutzschaltgerät, Signalwandler oder dergleichen zur Umsetzung von Schalt- und/oder Steuerungskonzepten.

Die EP 1 058 348 A1 zeigt eine modulare Installationsgerätebaugruppe, bei der die elektrischen Kontakte von Isolationsmitteln so umgeben sind, dass ein Berührungsschutz gegeben ist.

Der Erfindung liegt die Aufgabe zugrunde, ein mit Anschlussmodulen ausrüstbares und ein Kontaktmittel aufweisendes Installationsgerät anzugeben, bei dem das ggf. spannungsführende Kontaktmittel zur Kontaktierung der zugehörigen Anschlussmodule gegen ein unbeabsichtigtes Berühren mit einfachen Mitteln geschützt ist.

Diese Aufgabe wird erfindungsgemäß durch die Merkmale des Patentanspruchs 1 gelöst; vorteilhafte Ausgestaltungen sind jeweils Gegenstand von weiteren Ansprüchen.

Durch den Einsatz eines end- und/oder längsseitig an dem jeweiligen Kontaktmittel angeordneten Isolationsmittels ist auch bei abgenommenem Anschlussmodul hinsichtlich der freiliegenden und ggf. spannungsführenden Kontaktmittel ein vorschriftengemäßer Berührungsschutz, insbesondere an den Modulplätzen des Installationsgerätes, mit-einfachen Mitteln gewährleistet.

Vorteilhafterweise sind die Isolationsmittel derart angeordnet, dass die entsprechenden Kontaktmittel end- und/oder längsseitig abgedeckt sind, wodurch sich die exponierten Flächen der Kontaktmittel reduzieren lassen.

Das jeweilige Isolationsmittel ist ferner als Isolätionswinkel, insbesondere als in das Gehäuse integrierbares Steckelement, ausführbar, durch den das im Hinblick auf den Berührungsschutz äbzudeckende Kontaktmittel auf einfache Weise sicherbar ist.

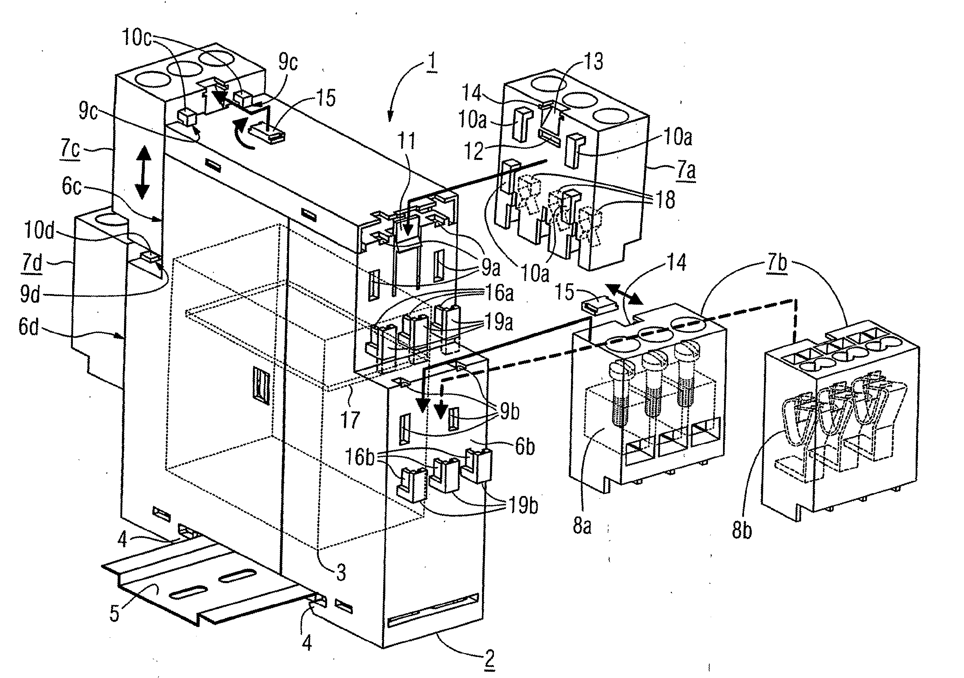

Die Erfindung sowie vorteilhafte Ausgestaltungen gemäß Merkmalen der weiteren Ansprüche werden im Folgenden anhand in der Zeichnung dargestellter Ausführungsbeispiele näher erläutert; darin zeigt die Figur ein Installationsgerät mit angeordneten und weiteren anordbaren Anschlussmodulen in einer perspektivischen Darstellung.

In der Figur ist ein modulares Installationsgerät 1 mit einem Gehäuse 2 gezeigt, das vorteilhafterweise eine schematisch dargestellte elektrische, elektromagnetische bzw. elektronische Geräteeinheit 3 aufweist. Mit der austauschbaren Geräteeinheit 3 ist der Verwendungszweck des Installationsgerätes 1 bestimmbar. Das Installationsgerät 1 weist ein in dem Gehäuse 2 integriertes Haltemittel 4 auf, das für ein daran ankoppelbares Tragemittel 5, insbesondere Hutschiene, vorgesehen ist. Das Tragemittel 5 ist beispielsweise in einem Verteiler, Schaltschrank oder dergleichen montiert, so dass das daran aufgeschnappte Installationsgerät 1 eine feste Einbaulage aufweist.

Das Installationsgerät 1 bzw. das Gehäuse 2 ist ferner mit mehreren Modulplätzen 6a-6d versehen, wobei ein erster und ein zweiter Modulplatz 6a und 6b für ein daran anordbares erstes bzw. zweites Anschlussmodul 7a bzw. 7b an einer Stirnseite des Gehäuses 2 vorgesehen sind. Ein an einer anderen Stirnseite angeordneter dritter und vierter Modulplatz 6c und 6d sind jeweils mit einem zugehörigen dritten bzw. vierten Anschlussmodule 7c bzw. 7d bestückt. Somit erübrigt sich bei einem Defekt bzw. bei Wartungsarbeiten an einem verdrahteten Gerät ein kompletter Austausch desselben, bei dem auch ein Lösen aller Anschlussmittel respektive aller Leitungen erforderlich wäre.

Das Anschlussmodul 7b ist stellvertretend für die anderen Anschlussmodule 7b-7d vorteilhafterweise jeweils mit einem mehrpoligen Anschlussmittel versehen. Zwei Ausführungsvarianten des Anschlussmoduls 7b zeigen zum einen eine vereinfacht dargestellte Schraubklemme 8a und zum anderen eine vereinfacht dargestellte Federzugklemme 8b als Anschlussmittel. Selbstverständlich sind weitere Ausführungsvarianten, wie beispielsweise eine Schneidklemme oder dergleichen, einsetzbar. Die Anschlussmittel sind jeweils für eine daran anschließbare - hier nicht dargestellte - ein- oder mehradrige Leitung bestimmt.

An dem ersten und an dem zweiten Modulplatz 6a und 6b sind ein erstes bzw. ein zweites Kodiermittel 9a bzw. 9b an einer Gehäusewand vorgesehen. Die beiden Kodiermittel 9a und 9b korrespondieren jeweils mit einem zugehörigen ersten Gegenkodiermittel 10a bzw. mit einem - hier nicht dargestellten - zweiten Gegenkontaktmittel. Das erste Gegenkontaktmittel 10a wie auch das zweite Gegenkontaktmittel sind Teil eines ersten bzw. eines zweiten Anschlussmoduls 7a bzw. 7b. Sowohl die Kontaktmittel 9a,9b als auch das erste Gegenkontaktmittel 10a und das zweite Gegenkontaktmittel dienen zur modulplatzspezifischen, also verwechslungsfreien Zuordnung des ersten bzw. des zweiten Anschlussmoduls 7a bzw. 7b an dem Gehäuse 2.

Gleiches trifft auf den dritten und vierten Modulplatz 6c und 6d zu, die jeweils mit einem dritten bzw. mit einem vierten Kodiermittel 9c bzw. 9d versehen sind. Das dritte und vierte Kodiermittel 9c und 9d ist jeweils mit einem zugehörigen dritten bzw. vierten Gegenkodiermittel 10c bzw. 10d des anordbaren dritten bzw. vierten Anschlussmoduls 7c bzw. 7d kompatibel. Die Kodiermittel 9a-9d an den Modulplätzen 6a-6d des Gehäuses 2 bzw. die Gegenkodiermittel 10a-10d an den Anschlussmodulen 7a-7d sind also insgesamt auf einfache Weise gegeneinander kodiert. Dies trifft sowohl auf Anschlussmodule einer Anschlussseite als auch auf Anschlussmodule verschiedener Anschlussseiten zu, so dass ein Zuordnungsfehler und damit u.U. eine Gerätezerstörung vermieden werden kann.

Hierbei ist beispielhaft das erste Kodiermittel 9a des ersten Modulplatzes 6a durch vier von Gehäuseabschnitten gebildete Ausnehmungen in der Gehäusewand ausgeführt. Die Ausnehmungen oder auch Durchbrüche unterscheiden sich in ihren Lagen, Positionen und/oder Abmessungen von denen des zweiten Kodiermittels 9b zum Zwecke der Individualisierung. Das erste Gegenkodiermittel 10a ist in diesem Ausführungsbeispiel als Winkelelement ausgeführt und in Lage, Position und/oder Abmessung entsprechend den Ausnehmungen des ersten Kodiermittels 9a ausgeprägt, so dass eine Verwechslung, z.B. mit dem zweiten oder dritten Anschlussmodul 7b oder 7c ausgeschlossen ist.

Vorteilhafterweise dienen die Winkelelemente zugleich als Befestigungshaken der Anschlussmodule 7a-7d an dem Gehäuse 2 des Installationsgerätes 1. Gleiches trifft selbstverständlich auch für alle anderen Modulplätze 6b-6d und Anschlussmodule 7b-7d zu, wobei je Modulplatz 6b-6d eine individuelle Ausführung des jeweiligen Kodiermittels 9b-9d und des entsprechenden zweiten bzw. dritten und vierten Gegenkodiermittels 10c und 10d gegeben ist. Die Kodiermittel 9a-9d sind in einer weiteren Ausgestaltung auch an den jeweiligen Anschlussmodulen 7a-7d vorsehbar, wobei die Gegenkodiermittel 10a-10d an dem Gehäuse 2 in einer geeigneten Ausrichtung angeordnet sind.

Der erste Modulplatz 6a weist weiterhin stirnseitig ein Rastmittel 11 in der Gehäusewand des Gehäuses 2 auf. Der dritte Modulplatz 6c ist ebenfalls mit einem derartigen - hier nicht dargestellten - Rastmittel ausgestattet. An dem ersten Anschlussmodul 7a ist ein Gegenrastmittel 12 vorgesehen, das in Wechselwirkung mit dem Rastmittel 11 zur modulplatzspezifischen Ver- und Entriegelung des ersten Anschlussmoduls 7a im Sinne einer Verriegelungsmechanik dient. Ein unbeabsichtigtes Lösen des ersten Anschlussmoduls 7a ist somit ausgeschlossen. Selbst bei auftretenden Zugkräften, die über eine angeschlossene Leitung eingeleitet werden können, ist ein Lösen der Anschlussmodule ausgeschlossen. Dies ist insofern von Bedeutung, als dass ein Lösen unter Lastverhältnissen auf Grund einer daraus resultierenden Lichtbogenbildung zu einem Kontaktabbrand sowie zu einer Überhitzung und im ungünstigsten Fall zur Zerstörung des Gerätes führen kann. Gleiches trifft sinngemäß auf das dritte Anschlussmodul 7c zu, wobei nach dem Aufschieben der Anschlussmodule 7a-7d das Rastmittel 11 mit dem Gegenrastmittel 12 verrastet. Das Rastmittel 11 ist als elastischer und einen Widerhaken aufweisender Riegel ausgeführt. Der Riegel umfasst seinerseits ein- oder mehrteilige federnde Elemente.

Vorteilhafterweise ist das Rastmittel 11 Teil der Gehäusewand, wodurch eine einfache und im Hinblick auf den Fertigungsaufwand reduzierte Ausführungsvariante gegeben ist. Auch das Gegenrastmittel 12 ist auf einfache Weise, nämlich als eine den Widerhaken aufnehmende Raste mit Vorteil ausgeführt. Der Riegel ist im Rahmen der Erfindung auch in einem der Anschlussmodule 7a-7d bzw. die Raste in dem Gehäuse 2 des Installationsgeräts 1 integrierbar. Die als Ausnehmung in einer Wandung des ersten Anschlussmoduls 7a ausgebildete Raste ist an einem Ende einer Rampe 13 angeordnet, über die beispielsweise mittels eines Schraubendrehers der Riegel gelöst werden kann.

An einem anderen Ende der Rampe 13 ist eine schlitzförmige Aufnahme 14 für ein darin einschiebbares Abschlusselement 15 vorgesehen. Das Abschlusselement 15 blockiert in eingeschobenem Zustand den Zugang zu dem Riegel und somit ein Entriegeln der Verriegelungsmechanik, so dass einer unerwünschten Demontage bzw. Abnahme des ersten Anschlussmoduls 7a vorgebeugt werden kann. Auf Grund der baulichen Überlappung des ersten Anschlussmoduls 7a gegenüber dem zweiten Anschlussmoduls 7b in an dem Installationsgerät 1 montiertem Zustand, erübrigt sich eine separate Verriegelungsmechanik für das zweite Anschlussmodul 7b, da dieses erst nach dem Lösen des ersten Anschlussmoduls 7a abgezogen werden kann.

An der einen Stirnseite, insbesondere an dem ersten Modulplatz 6a, des Gehäuses 2 ist ein erstes Kontaktmittel 16a angeordnet. An dem stufenartig abgesetzten zweiten Modulplatz 6b ist analog zu dem ersten Modulplatz 6a ein zweites Kontaktmittel 16b vorgesehen. Die an der Stirnseite herausragenden Kontaktmittel 16a,16b sind Teil eines - hier nicht gezeigten - s.g. Kontaktträgers. Der Kontaktträger ist auf einer Leiterplatte 17 der Geräteeinheit 3 platziert und befestigt. Der Kontaktträger dient u.a. als elektrisch leitende Verbindung zwischen den Kontaktmitteln 16a,16b und der Leiterplatte 17. Das zu dem ersten Kontaktmittel 16a zugehörige erste Anschlussmodul 7a ist mit einem vereinfacht dargestellten Gegenkontaktmittel 18 versehen, das innerhalb des ersten Anschlussmoduls 7a hinter einer Aussparung des zugehörigen Modulgehäuses angeordnet ist.

Das erste Kontaktmittel 16a bildet zusammen mit dem Gegenkontaktmittel 18 eine Anschlussschnittstelle zwischen dem Installationsgerät 1 und dem ersten Anschlussmodul 7a. Das erste Kontaktmittel 16a weist eine Längsseite auf, die zu einer Oberseite des Installationsgeräts 1 ausgerichtet ist. Beim Zuführen des ersten Anschlussmoduls 7a an den ersten Modulplatz 6a des Installationsgeräts 1 in Richtung des ersten Kontaktmittels 16a und entlang der einen Stirnseite, ist das erste Kontaktmittel 16a quer zu seiner Längsseite mit dem Gegenkontaktmittel 18 kontaktierbar, woraus sich eine senkrechte Kontaktierungsrichtung bzw. vertikale An- und Abkoppelrichtung ergibt. Im Gegensatz zu einem Einbaugerät mit einer horizontalen An- und Abkoppelrichtung hinsichtlich der Anschlussmodule, ist mit dem vorliegenden Installationsgerät 1 eine Demontage der Anschlussmodule 7a-7d auch bei einem geringen Zeilenabstand, beispielsweise im Schaltschrank, gewährleistet.

Vorteilhafterweise ist das erste Kontaktmittel 16a als eine Gruppe von flachen Kontaktelementen, insbesondere als Kontaktzungen oder als Kontaktfahnen, bzw. als Kontaktstifte ausgeführt. Die flachen Kontaktelemente sind mit ihrer flachen Seite parallel zu Seitenflächen des Gehäuses 2 angeordnet, wobei deren Anzahl frei wählbar ist. Zur Einhaltung der Kompatibilität ist das Gegenkontaktmittel 18 mit Vorteil als eine Gruppe von gabelförmigen Kontaktelementen ausgebildet, wodurch eine einfache und kontaktbegünstigende elektrisch leitende Kontaktverbindung gegeben ist. Das Gegenkontaktmittel 18 steht stellvertretend für alle anderen Gegenkontaktmittel der weiteren Anschlussmodule 7b-7d. Mittels der gabelförmigen Kontaktelemente - auch Federkontakte oder Tulpenkontakte genannt - ist hierbei eine lösbare Verbindung mit den flachen Kontaktelementen gegeben. Sinngemäß finden sich diese baulichen Ausgestaltungen auch an den weiteren Modulplätzen 6b-6d bzw. an den weiteren Anschlussmodulen 7b-7d wieder.

In den einzelnen Anschlussmodulen 7a-7d sind u.a. - hier nicht gezeigte - Stanz-Biegeteile integriert, die eine elektrisch leitende Verbindung einerseits zu dem jeweiligen Anschlussmittel und andererseits zu dem entsprechenden Gegenkontaktmittel gewährleisten. Selbstverständlich ist eine Ausführungsvariante des Installationsgeräts 1 mit gabelförmigen Kontaktelementen realisierbar, bei der die flachen Kontaktelementen Teil eines Anschlussmoduls sind.

An dem ersten und dem zweiten Kontaktmittel 16a und 16b sind beispielhaft end- und längsseitig ein erstes und ein zweites Isolationsmittel 19a und 19b im Sinne einer Berührungsschutzvorrichtung angeordnet. Das jeweilige als Gruppe von Isolationselementen ausgeführte Isolationsmittel 19a bzw. 19b deckt die zugehörigen Kontaktmittel 16a bzw. 16b ab, so dass vorteilhafterweise eine Berührung der ggf. spannungsführenden Kontaktmittel 16a bzw. 16b nach einem Abziehen der Anschlussmodule 7a bzw. 7b ausgeschlossen ist.

Die im vorliegenden Beispiel als Isolationswinkel bzw. als strichliert dargestellte Isolationsfortsätze ausgeführten Isolationsmittel 19a,19b gewährleisten die Einhaltung der Erfordernisse einschlägiger Normen, so z.B. der EN 61140 "Schutz gegen elektrischen Schlag". Die auch als Fingersicherheitsnasen bezeichneten Isolationsmittel 19a,19b können in einer vorteilhaften Weiterbildung auch als in das Gehäuse 2 integrierbare Steckelemente ausgeführt werden. Bei entsprechender Ausführung des Gehäuses 2 mit korrespondierenden Aufnahmen ist eine aufwandsarme Nachrüstung derartiger Isolationsmittel durchführbar.

Die Isolationsmittel 19a,19b sind ferner parallel bzw. senkrecht zur Längsseite des entsprechenden Kontaktmittels 16a,16b angeordnet, wodurch ein effektiver Berührungsschutz bei einem geringen Aufwand und Materialeinsatz gegeben ist. Weiterhin ist das Gehäuse 2 mit den Isolationsmitteln 19a,19b als einstückiger, also als teilereduzierter Verbund ausgebildet. Hierbei ist der Verbund durch eine vordefinierbare Spritzgussform an die gerätespezifischen Anforderungen anpassbar. Im Rahmen der Erfindung sind die Isolationsmittel 19a,19b in sinngemäßer Weise, insbesondere bei einer Ausführung mit flachen Kontaktelementen, auch an den Anschlussmodulen 7a-7d vorsehbar.

Durch die entsprechend der Kontaktierungsrichtung vorgegebenen Zuführungsrichtung der Anschlussmodule 7a-7d gemäß des mittels Zuführpfeilen dargestellten Montageablaufs, ergibt sich die Ausgestaltung der Kodier- und Gegenkodiermittel 9a-9d und 10a-10d, der Rast- und Gegenrastmittel 11 und 12 sowie der Isolationsmittel 19. Die Kodier- und Gegenkodiermittel 9a-9d und 10a-10d, das Rast- und Gegenrastmittel 11 und 12 sowie das Isolationsmittel 19 sind im Hinblick auf die beschriebenen vorteilhaften Ausführungsbeispiele ebenso durch gleichwirkende, jedoch zu den vorgenannten Mitteln unterschiedliche, Ausführungsvarianten realisierbar. -

Die An- und Abkopplung des ersten Anschlussmoduls 7a an dem Installationsgerät 1 erfolgt - stellvertretend für die weiteren Anschlussmodule 7b-7d - im Wesentlichen senkrecht zu der Längsachse des ersten Kontaktmittels 16a. Durch die Ankopplung der jeweiligen Anschlussmodule 7a-7d an den Modulplätzen 6a-6d ist folglich eine Anordnung gegeben, die eine elektrische Kontaktierung und eine mechanische Verbindung inklusive Kodierung und Verriegelung im Sinne einer Wirkverbindung bedingt. Daraus ergibt sich selbst bei einer beengten Anordnung des Installationsgerätes 1, beispielsweise zwischen Verdrahtungskanälen in einem Schaltschrank, ein komfortabler Zugang.

Sofern eines oder mehrere der Anschlussmodule 7a-7d zu Reparatur- oder Nachrüstzwecken abgenommen werden sollen, erfolgt zuerst eine Entriegelung der Verriegelungsmechanik mittels eines Werkzeuges. Hierbei wird der Widerhaken des Riegels aus der Raste gedrückt und das entsprechende Anschlussmodul kann abgenommen werden. Bei Wiedermontage ist auf Grund der Kodier- und Gegenkodiermittel 9a-9d und 10-10d eine eindeutige Zuordnung aller gelösten Anschlussmodule zu dem entsprechenden Modulplatz sichergestellt.

Die zuvor erläuterte Erfindung kann wie folgt zusammengefasst werden: Um ein mit zumindest einem Anschlussmodul 7a-7d ausrüstbares und ein Kontaktmittel 16a,16b aufweisendes Installationsgerät 1 anzugeben, bei dem das ggf. spannungsführende Kontaktmittel 16a,16b zur Kontaktierung des an- und ankoppelbaren Anschlussmoduls 7a-7d gegen ein unbeabsichtigtes Berühren mit einfachen Mitteln geschützt sein soll, ist vorgesehen, dass ein Isolationsmittel 19a,19b end- und/oder längsseitig an dem Kontaktmittel 16a,16b angeordnet ist.

## Patentansprüche

1. Modulares Installationsgerät (1),
- mit einem zumindest einen Modulplatz (6a-6d) aufweisenden Gehäuse (2);
- mit zumindest einem Anschlussmodul (7a-7d), das an dem Modulplatz (6a-6d) anordbar und mit einem Anschlussmittel für eine daran anschließbare Leitung versehen ist;
- mit einem Kontaktmittel (16a,16b) je Modulplatz (6a-6d) und einem Gegenkontaktmittel (18) je Anschlussmodul (7a-7d), wobei das Kontaktmittel (16a,16b) mit dem Gegenkontaktmittel (18) kontaktierbar ist; **gekennzeichnet durch**
- ein end- und längsseitig an dem Kontaktmittel (16a,16b) angeordnetes und als Winkel ausgebildetes Isolationsmittel (19), das das Kontaktmittel (16a,16b,) end- und längsseitig abdeckt.

2. Modulares Installationsgerät nach Anspruch 1,
wobei das Isolationsmittel (19) als Steckelement in das Gehäuse integrierbar ist.

3. Modulares Installationsgerät nach einem der vorhergehenden Ansprüche,
wobei das Isolationsmittel (19) parallel bzw. senkrecht zur Längsseite des Kontaktmittels (16a,16b) anordbar ist.

4. Modulares Installationsgerät nach einem der vorhergehenden Ansprüche,
wobei das Gehäuse (2) und das Isolationsmittel (19) als einstückiger Verbund ausgebildet sind.

5. Modulares Installationsgerät nach Anspruch 1,
mit einer Ausführung des Kontaktmittels (16a,16b) mit einer Längsseite, wobei das Kontaktmittel (16a,16b) quer zu der Längsseite mit dem Gegenkontaktmittel (18) kontaktierbar ist.

6. Modulares Installationsgerät nach Anspruch 1,
mit einem federbeaufschlagten Haltemittel (4) für ein daran ankoppelbares Tragemittel (5).

7. Modulares Installationsgerät nach Anspruch 1,
mit einem Kodiermittel (9a-9d) an zumindest dem einen Modulplatz (6a-6d) sowie einem Gegenkodiermittel (10a-10d) an zumindest dem einen Anschlussmodul (7a-7d) zur modulplatzspezifischen Zuordnung.

8. Modulares Installationsgerät nach Anspruch 1,
mit einem Rastmittel (11) je Modulplatz (6a-6d) und einem Gegenrastmittel (12) je Anschlussmodul (7a-7d) zur modulplatzspezifischen Ver- und Entriegelung.

9. Modulares Installationsgerät nach Anspruch 1,
mit einer elektrischen, elektromagnetischen bzw. elektronischen Geräteeinheit (3).

## Claims

1. Modular service device (1),
- having a housing (2) having at least one module location (6a-6d);
- having at least one connection module (7a-7d) which can be arranged at the module location (6a-6d) and is provided with a connection means for a line which can be connected thereto;
- having a contact means (16a, 16b) per module location (6a-6d) and an opposing contact means (18) per connection module (7a-7d), it being possible for the contact means (16a, 16b) to make contact with the opposing contact means (18); **characterized by**
- an insulating means (19) which is in the form of a bracket, is arranged on the end and longitudinal side on the contact means (16a, 16b) and covers the contact means (16a, 16b) on the end and longitudinal side.

2. Modular service device according to Claim 1, it being possible for the insulating means (19) to be integrated as a plug-in element in the housing.

3. Modular service device according to one of the preceding claims,
it being possible for the insulating means (19) to be arranged parallel or perpendicular to the longitudinal side of the contact means (16a, 16b).

4. Modular service device according to one of the preceding claims,
the housing (2) and the insulating means (19) being in the form of an integral composite.

5. Modular service device according to Claim 1, having a design of the contact means (16a, 16b) having a longitudinal side, it being possible for the contact means (16a, 16b) to make contact with the opposing contact means (18) transversely with respect to the longitudinal side.

6. Modular service device according to Claim 1, having a spring-loaded retaining means (4) for a bearing means (5) which can be coupled thereto.

7. Modular service device according to Claim 1, having a coding means (9a-9d) at at least one module location (6a-6d) and an opposing coding means (10a-10d) ON at least one connection module (7a-7d) for the purpose of providing module location-specific assignment.

8. Modular service device according to Claim 1, having a latching means (11) per module location (6a-6d) and an opposing latching means (12) per connection module (7a-7d) for the purpose of providing module location-specific locking and unlocking.

9. Modular service device according to Claim 1, having an electrical, electromagnetic or electronic device unit (3).

## Revendications

1. Appareil (1) modulaire de câblage,
- comprenant un boîtier (2) ayant au moins un emplacement (6a à 6d) de module ;
- comprenant au moins un module (7a à 7d) de connexion, qui peut être mis à l'emplacement (6a à 6d) de module et qui est muni d'un moyen de connexion pour une ligne pouvant s'y raccorder ;
- comprenant un moyen (16a, 16b) de contact par emplacement (6a, 6b) de module et un moyen (18) de contre contact par module (7a à 7b) de connexion, les moyens (16a, 16b) de contact pouvant être mis en contact avec le moyen (18) de contre contact, **caractérisé par** un moyen (19) isolant disposé du côté de l'extrémité et du côté longitudinal sur le moyen (16a, 16b) de contact et constitué sous la forme d'une équerre qui recouvre le moyen (16a, 16b) de contact du côté de l'extrémité et du côté longitudinal.

2. Appareil modulaire de câblage suivant la revendication 1,
dans lequel le moyen (19) isolant peut être intégré dans le boîtier sous la forme d'un élément à enficher.

3. Appareil modulaire de câblage suivant l'une quelconque des revendications précédentes, dans lequel le moyen (19) isolant peut être disposé parallèlement ou perpendiculairement au côté longitudinal du moyen (16a, 16b) de contact.

4. Appareil modulaire de câblage suivant l'une quelconque des revendications précédentes, dans lequel le boîtier (2) et le moyen (19) isolant sont constitués sous la forme d'un composite d'un seul tenant.

5. Appareil modulaire de câblage suivant la revendication 1, comprenant une réalisation du moyen (16a, 16b) de contact avec un côté longitudinal, le moyen (16a, 16b) de contact pouvant être mis en contact avec le moyen (18) de contre contact transversalement au côté longitudinal.

6. Appareil modulaire de câblage suivant la revendication 1, comprenant un moyen (4) de maintien, qui est soumis à l'action d'un ressort et qui est destiné à maintenir un moyen (5) de support pouvant y être accouplé.

7. Appareil modulaire de câblage suivant la revendication 1, comprenant un moyen (9a à 9d) de codage sur au moins sur un emplacement (6a, 6d) de module, ainsi qu'un moyen (10a à 10d) de contre codage sur au moins le un module (7a à 7d) de connexion pour une association spécifique à l'emplacement du module.

8. Appareil modulaire de câblage suivant la revendication 1, comprenant un moyen (11) d'encliquetage par emplacement (6a à 6d) de module et un moyen (12) de contre encliquetage par module (7a à 7d) de connexion pour le verrouillage et le déverrouillage spécifique à un emplacement de module.

9. Appareil modulaire de câblage suivant la revendication 1, comprenant une unité (3) d'appareil électrique électromagnétique ou électronique.
